# EUROPEAN PATENT APPLICATION

(11) **EP 3 489 977 A1**
(43) Date of publication of application: **29.05.2019**
(21) Application number: 17831114.8
(22) Date of filing: 20.07.2017
(51) Int. Cl.: H01G 9/20

(54) **DYE-SENSITIZED SOLAR CELL, DYE-SENSITIZED SOLAR CELL MODULE AND METHOD FOR MANUFACTURING DYE-SENSITIZED SOLAR CELL**

(30) Priority: 22.07.2016 JP 2016144417
(71) Applicant: Sharp Kabushiki Kaisha, Sakai City, Osaka 590-8522 (JP)
(72) Inventor: YOSHIE, Tomohisa, Sakai City, Osaka 590-8522 (JP); FUKUI, Atsushi, Sakai City, Osaka 590-8522 (JP); KASAHARA, Kei, Sakai City, Osaka 590-8522 (JP); NISHIMURA, Naoto, Sakai City, Osaka 590-8522 (JP); TOYOSHIMA, Daisuke, Sakai City, Osaka 590-8522 (JP)
(74) Representative: Müller Hoffmann & Partner
(86) International application number: PCT/JP2017/026318
(87) International publication number: WO 2018/016598

(57) **Abstract**

A dye-sensitized solar cell (100) includes: a first light-transmitting substrate and a second substrate (12, 32); an electrolytic solution (42); a transparent conductive layer (14); a porous semiconductor layer (18a); a photosensitizer supported on the porous semiconductor layer; a first sealing member (45) that forms a space (S) between the first light-transmitting substrate and the second substrate, the space being filled with the electrolytic solution (42), the space (S) including an injection hole (51) that has an opening (50) for injecting the electrolytic solution (42); and a second sealing member (52) that seals the injection hole (51) to thereby hermetically seal the space (S). In a cross section parallel to a principal surface of the first light-transmitting substrate (12) and including the injection hole (51), a distance H is larger than a width h of the opening (50) of the injection hole (51), where the distance H is the distance between two contact points at which the first sealing member (45), the second sealing member (52), and the electrolytic solution (42) are in contact with each other.

## Description

### Technical Field

The present disclosure relates to a dye-sensitized solar cell, to a dye-sensitized solar cell module, and to a method for manufacturing the dye-sensitized solar cell. In the present description, the unit structure of a solar cell is referred to as a cell, and a plurality of cells integrated into a package is referred to as a module.

### Background Art

Solar cells are broadly classified according to their materials into three types: silicon-based solar cells, compound-based solar cells, and organic-based solar cells. The silicon-based solar cells have high conversion efficiency, and solar cells using polysilicon are most widely used for power generation using sunlight. Dye-sensitized solar cells (hereinafter may be referred to as "DSCs") are one type of organic-based solar cell. The DSCs are inferior to the silicon-based solar cells in terms of conversion efficiency but have an advantage in that their manufacturing cost is lower than that of silicon-based and compound-based solar cells that use inorganic semiconductors, and attention is focused on the DSCs in recent years. Another advantage of the DSCs is that high power generation efficiency can be obtained even in a low-illuminance environment, and attention is also drawn in this respect.

Typically, a DSC module includes a plurality of DSCs (cells), and the DSCs are electrically connected in series or in parallel. Examples of the structure of the DSC module include a W-type integrated structure, a Z-type integrated structure, a monolithic integrated structure, and a grid-type integrated structure. Generally, a DSC module is provided with an electrolytic solution containing a redox couple and filled into a space defined by two substrates and a sealing member (a sealing material) and is partitioned into cell units by the sealing member. The DSC module has an opening for injecting the electrolytic solution, and the opening is sealed with a sealing material to prevent the electrolytic solution from leaking to the outside. In the present description, the former sealing material is denoted as a "first sealing material," and the latter sealing material is denoted as a "second sealing material." In the present description, the term "sealing material" and the term "sealing member" may be used interchangeably.

PTL 1 discloses a dye-sensitized solar cell module provided with injection portion (an opening portion) formed of a hot melt resin sealant for injecting an electrolytic solution, and the injection portion heated and pressurized to seal. PTL 2 discloses a dye-sensitized solar cell module in which a sealing material formed of a hot melt resin and filling an injection portion for injecting an electrolytic solution is heat-fused to thereby seal the injection portion. In these structures, the sealing material prevents leakage of the electrolyte.

PTL 3 discloses a dye-sensitized solar cell module having a sealing structure in which a sealing member in an electrolytic solution injection hole is not in direct contact with an electrolytic solution. The electrolytic solution injection hole has an empty portion not filled with the electrolytic solution and disposed between the sealing member and the electrolytic solution. With this structure, resistance to electrolytic solution leakage can be improved.

### Citation List

### Patent Literature

PTL 1: Japanese Patent No. 4639657
PTL 2: Japanese Unexamined Patent Application Publication No. 2014-26872
PTL 3: Japanese Unexamined Patent Application Publication No. 2004-119149

### Summary of Invention

### Technical Problem

However, the inventors have conducted studies on a DSC module and found the following problem. The electrolytic solution contains a highly volatile organic solvent. Therefore, when the DSC module is used at high temperature, the internal temperature or internal pressure of the DSC module increases, and the electrolytic solution leaks from the opening to the outside. Suppose, for example, that the DSC module is disposed near a heat source such as a fluorescent lamp. In this case, the electrolytic solution is heated, and the vapor pressure of the organic solvent is assumed to increase. When the internal pressure of the DSC module in, for example, PTL 1 or 2 increases, a force that presses the sealing material toward the outside (a force acting to separate the sealing material from the opening) is generated at the interface between the opening and the sealing material, and interfacial peeling occurs. Therefore, a leakage path for the electrolytic solution may be formed at the interface between the opening and the sealing material. It can be said that the adhesion of the hot melt resin etc. is insufficient to prevent the interfacial peeling caused by the increase in internal pressure.

It is an object of the present disclosure to provide a dye-sensitized solar cell in which the resistance to electrolytic solution leakage can be further improved and more particularly to provide a dye-sensitized solar cell in which the resistance to electrolytic solution leakage at increased temperature can be improved.

### Solution to Problem

A dye-sensitized solar cell according to an embodiment of the present invention includes: a first light-transmitting substrate and a second substrate; an electrolytic solution; a transparent conductive layer disposed on an electrolytic solution side of the first light-transmitting substrate; a porous semiconductor layer disposed on a second substrate side of the transparent conductive layer; a photosensitizer supported on the porous semiconductor layer; a counter electrode disposed on a second substrate side of the porous semiconductor layer; a first sealing member that forms a space between the first light-transmitting substrate and the second substrate, the space being filled with the electrolytic solution, the space including an injection hole that has an opening for injecting the electrolytic solution; and a second sealing member that seals the injection hole to thereby hermetically seal the space, wherein, in a cross section parallel to a principal surface of the first light-transmitting substrate and including the injection hole, a distance H is larger than a width h of the opening of the injection hole, where the distance H is a distance between two contact points at which the first sealing member, the second sealing member, and the electrolytic solution are in contact with each other.

In one embodiment, in the cross section, an angle θ between the first sealing member and the second sealing member at each of the two contact points is 90° or more and less than 180°.

In one embodiment, in the cross section, the injection hole has a rectangular shape.

In one embodiment, in the cross section, a width of the injection hole increases as a distance from the opening increases.

In one embodiment, in the injection hole in the cross section, a boundary between the first sealing member and the second sealing member has a rounded shape.

In one embodiment, in the cross section, the second sealing member has a convex shape protruding toward the electrolytic solution.

In one embodiment, in the cross section, the second sealing member has a convex shape protruding toward the electrolytic solution, and the relations H/h ≥ 1.68 and 0.83 ≥ h/L hold, where L is a distance from an apex of the convex shape to a first one of two opposite sides of the rectangular shape, a second one of the two opposite sides corresponding to the opening.

In one embodiment, in the cross section, the second sealing member has a convex shape protruding toward the electrolytic solution, and the relations H/h ≥ 1.68 and 0.83 ≥ h/L hold, where L is a distance from an apex of the convex shape to the opening.

In one embodiment, when the dye-sensitized solar cell is viewed in a direction normal to the principal surface, an edge of the first light-transmitting substrate, an edge of the second substrate, and the opening are aligned with each other.

In one embodiment, the dye-sensitized solar cell further includes a second transparent conductive layer that is disposed on the electrolytic solution side of the first light-transmitting substrate so as to be separated from the first transparent conductive layer, and the counter electrode is electrically connected to the second transparent conductive layer.

In one embodiment, a dye-sensitized solar cell module includes a plurality of the dye-sensitized solar cells according to any of the above embodiments, and the plurality of dye-sensitized solar cells are electrically connected in series or in parallel.

In one embodiment, a dye-sensitized solar cell module includes a plurality of the dye-sensitized solar cells, each of which further includes a second transparent conductive layer that is disposed on the electrolytic solution side of the first light-transmitting substrate so as to be separated from the first transparent conductive layer, the counter electrode being electrically connected to the second transparent conductive layer. The plurality of dye-sensitized solar cells include two dye-sensitized solar cells connected in series, and the first transparent conductive layer included in a first one of the two dye-sensitized solar cells is electrically connected to the second transparent conductive layer included in a second one of the two dye-sensitized solar cells.

In one embodiment, a dye-sensitized solar cell module includes a plurality of the dye-sensitized solar cells, each of which further includes a second transparent conductive layer that is disposed on the electrolytic solution side of the first light-transmitting substrate so as to be separated from the first transparent conductive layer, the counter electrode being electrically connected to the second transparent conductive layer. Two adjacent dye-sensitized solar cells of the plurality of dye-sensitized solar cells share the first light-transmitting substrate, the second substrate, and the first sealing member, the first sealing member including extending portions protruding outward, the second sealing member further sealing a space defined by an outer wall of each of the extending portions, an outer wall of the first sealing member, the first light-transmitting substrate, and the second substrate.

In one embodiment, a distance from an edge of a first one of the first light-transmitting substrate and the second substrate to the opening of each injection hole is longer than a distance from an edge of a second one of the first light-transmitting substrate and the second substrate to the opening of the each injection hole.

A method for manufacturing a dye-sensitized solar cell in an embodiment of the present invention includes the steps of: providing a first light-transmitting substrate including a transparent conductive layer formed thereon; forming a porous semiconductor layer on the transparent conductive layer; adsorbing a photosensitizer on the porous semiconductor layer; forming a space to be filled with an electrolytic solution between the first substrate and a second substrate by laminating the first light-transmitting substrate onto the second substrate through a first sealing material and then curing the first sealing material; forming an injection hole having an opening for injecting the electrolytic solution into the space; after the pressure inside the space is reduced to a pressure range of from 200 Pa to 5,000 Pa inclusive within a vacuum chamber, injecting the electrolytic solution into the space by bringing the electrolytic solution into contact with the opening and then opening the vacuum chamber to atmosphere; and, after injection of the electrolytic solution into the space, hermetically sealing the space by providing a second sealing material to the injection hole, leaving a pre-module to stand in a thermostatic chamber in a temperature range of from -40°C to 0°C inclusive for a prescribed time to thereby draw the second sealing material to an electrolytic solution side of the injection hole, and, after completion of drawing of the second sealing material, curing the second sealing material within the thermostatic chamber.

In one embodiment, in the step of injecting the electrolytic solution, the pressure inside the vacuum chamber is 3,000 Pa.

In one embodiment, in the step of hermetically sealing the space, the temperature of the thermostatic chamber is -20°C.

In one embodiment, in the step of hermetically sealing the space, the prescribed time is from 1 minute to 10 minutes inclusive.

In one embodiment, in the step of forming the space, the first sealing material is cured to form a first sealing member. In the step of hermetically sealing the space, the second sealing material is cured to form a second sealing member. The method of manufacturing further includes, after the step of hermetically sealing the space, the step of obtaining the dye-sensitized solar cell in which, in a cross section parallel to a principal surface of the first substrate and including the injection hole, a distance H is larger than a width h of the opening of the injection hole, where the distance H is a distance between two contact points at which the first sealing member, the second sealing member, and the electrolytic solution are in contact with each other.

### Advantageous Effects of Invention

According to the embodiments of the invention, a dye-sensitized solar cell in which resistance to electrolytic solution leakage can be further improved is provided. Brief Description of Drawings
Fig. 1 is a schematic plan view of a DSC module 200 in embodiment 1.
Fig. 2 is a cross-sectional view schematically showing a cross-sectional structure of a DSC 100 in embodiment 1, the cross-sectional structure being parallel to the xz plane.
Fig. 3 is a cross-sectional view schematically showing a cross-sectional structure of the DSC module 200 including a plurality of DSCs 100, the cross-sectional structure being parallel to the yz plane.
Fig. 4 is a cross-sectional view schematically showing a cross section of the DSC module 200 with its injection holes 51 not sealed, the cross section being parallel to a principal surface of the transparent substrate 12 (the cross section being parallel to the xy plane).
Fig. 5 is a side view schematically showing a side surface of the DSC module 200 with an injection hole 51 (opening 50) sealed with a second sealing member 52, the side surface being viewed in the x-axis direction.
Fig. 6 is a cross-sectional view schematically showing a cross section of the DSC module 200 with the injection hole 51 (opening 50) sealed with the second sealing member 52, the cross section being parallel to the principal surface of the transparent substrate 12 (the cross section being parallel to the xy plane).
Fig. 7 is an enlarged view schematically showing the right one of two contact points in the cross section in Fig. 6.
Fig. 8A is an illustration schematically showing how the internal pressure of an electrolytic solution 42 acts on a convex shape 52C.
FIG. 8B is an illustration schematically showing how the internal pressure of the electrolytic solution 42 acts on the apex of the second sealing member 52 when the apex is rectangular in its cross section.
Fig. 8C is an illustration schematically showing how the internal pressure of the electrolytic solution 42 acts on the apex of the second sealing member 52 when the apex has an inclination in its cross section.
Fig. 9 is a flowchart exemplifying a flow of a method for manufacturing the DSC module 200.
Fig. 10 is a cross-sectional view schematically showing a cross section of a DSC module 200 in embodiment 2 with an injection hole 51 sealed with a second sealing member 52, the cross section being parallel to the principal surface of the transparent substrate 12 (the cross section being parallel to the xy plane).
Fig. 11 is a cross-sectional view schematically showing a cross section of a DSC module 200 in embodiment 3 with an injection hole 51 sealed with a second sealing member 52, the cross section being parallel to the principal surface of the transparent substrate 12 (the cross section being parallel to the xy plane).
Fig. 12 is a cross-sectional view schematically showing a cross section of the DSC module 200 in embodiment 3 with an injection hole 51 sealed with a second sealing member 52, the cross section being parallel to the principal surface of the transparent substrate 12 (the cross section being parallel to the xy plane).
Fig. 13 is a cross-sectional view schematically showing a cross section of a DSC module 300 in embodiment 4, the cross section being parallel to the principal surface of the transparent substrate 12 (the cross section being parallel to the xy plane) and showing the vicinities of injection holes 51a and 51b of two dye-sensitized solar cells 100a and 100b of a plurality of dye-sensitized solar cells 100, the injection holes 51a and 51b being sealed with the second sealing material.
Fig. 14A is a cross-sectional view schematically showing a cross-section of the DSC module 300 taken along broken line AA' in Fig. 13 (a cross section parallel to the xz plane).
Fig. 14B is a cross-sectional view schematically showing a cross-section of the DSC module 300 taken along broken line BB' in Fig. 13 (a cross section parallel to the xz plane).
Fig. 14C is a cross-sectional view schematically showing a cross-section of the DSC module 300 taken along broken line CC' in Fig. 13 (a cross section parallel to the xz plane).
Fig. 15 is a cross-sectional view schematically showing a DSC module in a Comparative Example with an injection hole 51 sealed with a second sealing member 52, the cross section being parallel to the principal surface of the transparent substrate 12 (the cross section being parallel to the xy plane).

### Description of Embodiments

The present inventors have focused attention on the shape of the second sealing material (sealing members) that seals openings and arrived at the present invention.

A dye-sensitized solar cell in an embodiment of the present invention includes: first and second substrates; an electrolytic solution; a transparent conductive layer disposed on an electrolytic solution side of the first substrate; a porous semiconductor layer disposed on an electrolytic solution side of the transparent conductive layer; a photosensitizer supported on the porous semiconductor layer; a first sealing member that forms a space between the first and second substrates, the space being filled with the electrolytic solution, the space including an injection hole that has an opening for injecting the electrolytic solution; and a second sealing member that seals the injection hole to thereby hermetically seal the space. In a cross section parallel to a principal surface of the first substrate and including the injection hole, a distance H is larger than the width h of the opening of the injection hole, where the distance H is the distance between two contact points at which the first sealing member, the second sealing member, and the electrolytic solution are in contact with each other. Typically, the first substrate is a transparent substrate, and the photosensitizer is a sensitizing dye. By electrically connecting a plurality of dye-sensitized solar cells in series or in parallel, a dye-sensitized solar cell module is obtained.

Dye-sensitized solar cell modules in embodiments of the present invention and a method for manufacturing a dye-sensitized solar cell module will be described with reference to the accompanying drawings. In the following description, the same or similar components are denoted by the same reference numerals. The exemplified embodiments of the present invention are not intended to limit the embodiments of the present invention.

### (Embodiment 1)

### [DSC module 200]

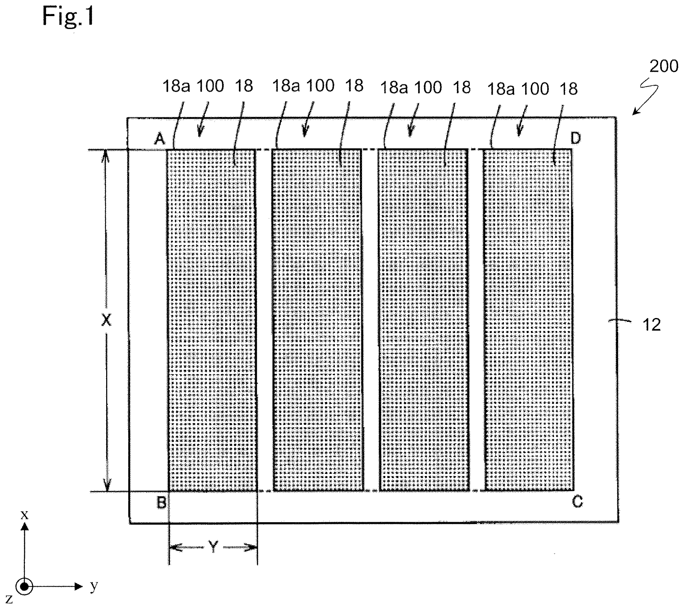

Fig. 1 is a schematic plan view of a DSC module 200 in the present embodiment. In Fig. 1, coordinate axes including mutually orthogonal x, y, and z axes are shown. In other accompanying drawings, similar coordinate axes are shown, and the x, y, and z axes designate the same directions in all the drawings.

DSCs 100 are connected in series according to the required output voltage and used as a module. The DSC module 200 includes a plurality of DSCs 100 electrically connected in series in the y direction and disposed on a transparent substrate 12. In Fig. 1, a series connection of four DSCs 100 is exemplified. For example, when a voltage of 0.5 V is obtained from each DSC 100, a total voltage of 2.0 V is obtained from the DSC module 200 as a whole. Of course, the number of DSCs 100 is not limited to four. The size of the transparent substrate 12 in the x direction is, for example, 4.0 cm, and its size in the y direction is, for example, 4.5 cm. The size X of each DSC 100 in the x direction is, for example, 3.0 cm, and its size in the y direction is, for example, 0.5 cm.

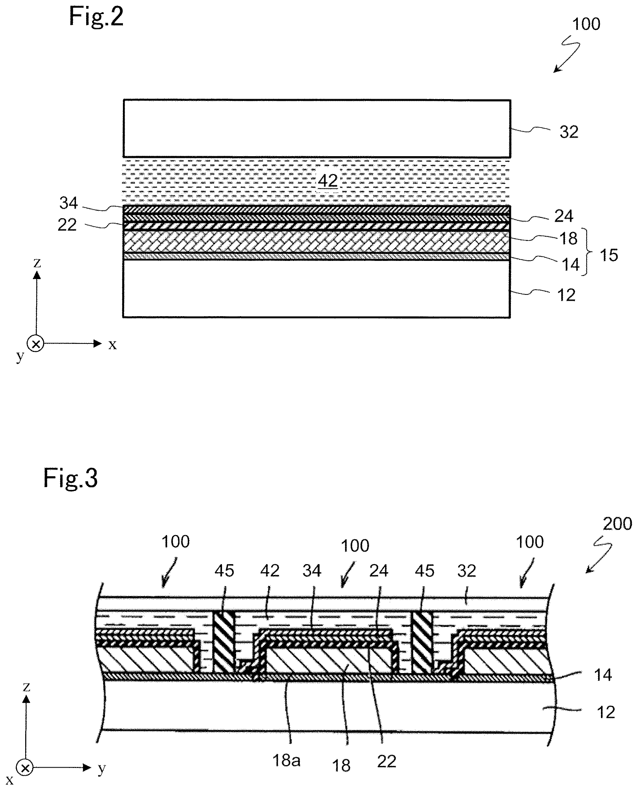

Fig. 2 schematically shows a cross-sectional structure of each DSC 100 in the present embodiment, the cross-sectional structure being parallel to the xz plane. Fig. 3 schematically shows a cross-sectional structure of the DSC module 200 including the plurality of DSCs 100, the cross-sectional structure being parallel to the yz plane. In this embodiment, the structure of the DSC module 200 having a monolithic integrated structure and the structure of the DSCs 100 corresponding to unit structures of the DSC module 200 will be described. However, embodiments of the present invention are not limited to the monolithic integrated structure, and the structure of the DSC module may be selected from the above-described various integrated structures.

As shown in Fig. 2, each DSC 100 includes: the transparent substrate 12; a photoelectrode 15 formed on the transparent substrate 12; a porous insulating layer 22 formed on the photoelectrode 15; a catalyst layer 24 formed on the porous insulating layer 22; a counter electrode 34 formed on the catalyst layer 24; a substrate 32; and an electrolytic solution (electrolyte solution) 42 that fills the space between the photoelectrode 15 and the substrate 32. The electrolytic solution 42 contains, for example, I⁻ and I₃⁻ as mediators (a redox couple). The electrolytic solution 42 enters the porous insulating layer 22 disposed between the photoelectrode 15 and the counter electrode 34. The electrolytic solution 42 held in the porous insulating layer 22 serves as a carrier transport layer. When the counter electrode 34 is formed on the substrate 32 such that the photoelectrode 15 and the counter electrode 34 do not come into physical contact with each other in the use environment of the DSC, the porous insulating layer 22 may be omitted.

The photoelectrode 15 of the DSC 100 includes: a transparent conductive layer 14 disposed on the substrate 32 side of the transparent substrate 12; a porous semiconductor layer 18a disposed on the substrate 32 side of the transparent conductive layer 14; and a sensitizing dye (not shown) supported on the porous semiconductor layer 18a. The porous semiconductor layer 18a including the sensitizing dye supported thereon may be referred to as a photoelectric conversion layer 18. The photosensitizer used may be, in addition to the sensitizing dye, for example, quantum dots.

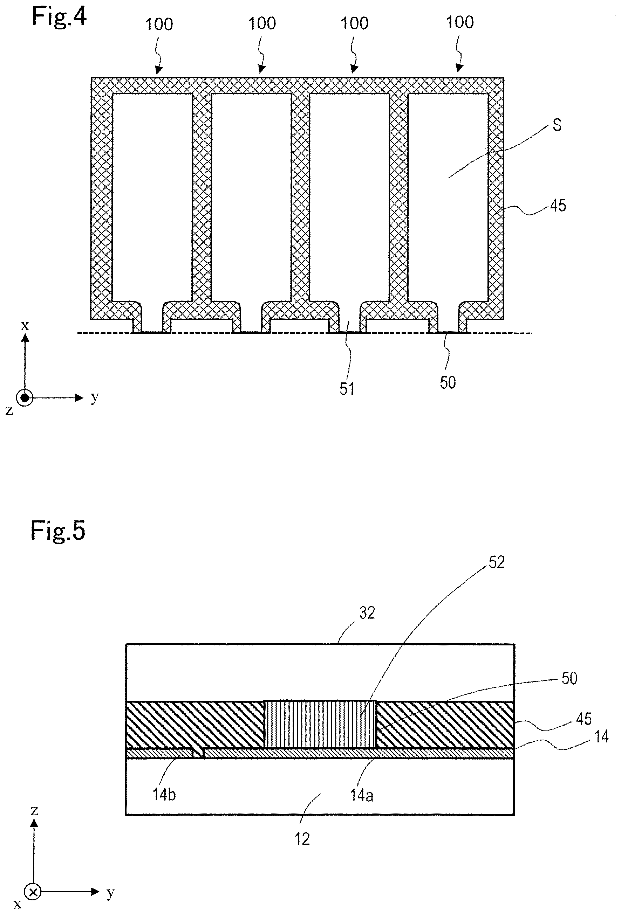

The transparent conductive layer 14 includes a first transparent conductive layer 14a and a second transparent conductive layer 14b (see Fig. 5). The first transparent conductive layer 14a and the second transparent conductive layer 14b are disposed on the transparent substrate 12 and arranged with an inter-transparent electrode region (gap) therebetween so as to be electrically isolated from each other.

When a structure in which the photoelectrode 15 to the counter electrode 34 are formed on the transparent substrate 12 (i.e., the monolithic integrated structure) as shown in Fig. 2 is used, the substrate 32 used can be, for example, a relatively low-cost glass plate. Such a substrate 32 (thinner than the transparent substrate 12) is occasionally referred to as a cover member. When the monolithic integrated structure is used, the substrate 32 does not need to have light-transmitting properties. Therefore, it is necessary to use only one relatively expensive glass substrate with an FTO layer (used as the transparent substrate 12 and the transparent conductive layer 14), and this is advantageous in that the cost of the DSC module can be reduced.

The transparent substrate 12 used may be a light-transmitting substrate having light-transmitting properties. However, it is only necessary that the transparent substrate 12 be formed of a material that can substantially transmit light with a wavelength in the effective sensitivity range of a sensitizing dye described later, and it is not always necessary that the transparent substrate 12 be optically transparent to the entire wavelength range of light. The thickness of the transparent substrate 12 is, for example, from 0.2 mm to 5.0 mm inclusive.

Substrate materials commonly used for solar cells can be used as the material of the transparent substrate 12. Examples of such a material include: substrates made of glass such as soda-lime glass, fused quartz glass, and crystalline quartz glass; and heat-resistant resin sheets such as flexible films. The flexible film used may be a film made of tetraacetylcellulose (TAC), polyethylene terephthalate (PET), polyphenylene sulfide (PPS), polycarbonate (PC), polyarylate (PA), polyetherimide (PEI), a phenoxy resin, or Teflon (registered trademark).

The transparent conductive layer 14 is formed of a material having electric conductivity and light-transmitting properties. The material used may be at least one selected from the group consisting of indium tin complex oxide (ITO), tin oxide (SnO₂), fluorine-doped tin oxide (FTO), and zinc oxide (ZnO). The thickness of the transparent conductive layer 14 is, for example, from 0.02 µm to 5.00 µm inclusive. The electrical resistance of the transparent conductive layer 14 is preferably as low as possible and is preferably 40 Ω/square or less.

The porous semiconductor layer 18a is formed of a photoelectric conversion material. The material used may be at least one selected from the group consisting of titanium oxide, zinc oxide, tin oxide, iron oxide, niobium oxide, cerium oxide, tungsten oxide, barium titanate, strontium titanate, cadmium sulfide, lead sulfide, zinc sulfide, indium phosphide, copperindium sulfide (CuInS₂), CuAlO₂, and SrCu₂O₂. It is preferable to use titanium oxide because of its high stability and a large bandgap.

The titanium oxide used for the porous semiconductor layer 18a may be, for example, titanium hydroxide, hydrous titanium oxide, or any of various titanium oxides in a narrow sense such as anatase-type titanium oxide, rutile-type titanium oxide, amorphous titanium oxide, metatitanic acid, and orthotitanic acid. These may be used alone or as a mixture. Crystalline titanium oxide can have any of the two crystalline structures of the anatase and rutile types, and this depends on its production method and thermal history. Generally, the crystalline titanium oxide is of the anatase type. From the viewpoint of dye sensitization, the titanium oxide used is preferably a titanium oxide with a high anatase content, e.g., a titanium oxide with an anatase content of 80% or more.

The semiconductor may be in either a single crystalline form or a polycrystalline form. From the viewpoint of stability, the ease of crystal growth, production cost, etc., the semiconductor is preferably polycrystalline, and nanoscale or microscale fine polycrystalline semiconductor particles are used preferably. Therefore, fine titanium oxide particles are preferably used as the raw material of the porous semiconductor layer 18a. The fine titanium oxide particles can be produced by, for example, a liquid phase method such as hydrothermal synthesis or a sulfuric acid method or a vapor phase method. The fine titanium oxide particles can also be produced by high temperature hydrolysis of a chloride developed by Degussa.

The fine semiconductor particles may be a mixture of fine semiconductor compound particles of the same type or different types that have at least two different diameters. Fine semiconductor particles with a larger diameter scatter incident light and may contribute to improvement in light-harvesting efficiency, and fine semiconductor particles with a smaller diameter provide an increased number of adsorption sites and may contribute to improvement in the adsorption amount of the sensitizing dye.

When fine semiconductor particles composed of a mixture of fine particles with different diameters are used, the ratio of the average diameters of the fine particles is preferably 10 or more. The average diameter of large-diameter fine particles may be, for example, from 100 nm to 500 nm inclusive. The average diameter of small-diameter fine particles may be, for example, from 5 nm to 50 nm inclusive. When fine semiconductor particles composed of a mixture of different semiconductor compounds are used, it is effective that particles of a semiconductor compound with a stronger adsorption action are reduced in diameter.

The thickness of the porous semiconductor layer 18a is, for example, from 0.1 µm to 100.0 µm inclusive. The specific surface area of the porous semiconductor layer 18a is, for example, from 10 m²/g to 200 m²/g inclusive.

A sensitizing dye is typically used as the photosensitizer supported on the porous semiconductor layer 18a. One or two or more of various organic dyes and metal complex dyes that absorb light in the visible range or the infrared range may be selectively used as the sensitizing dye.

The organic dye used may be, for example, at least one selected from the group consisting of azo-based dyes, quinone-based dyes, quinonimine-based dyes, quinacridone-based dyes, squarylium-based dyes, cyanine-based dyes, merocyanine-based dyes, triphenylmethane-based dyes, xanthene-based dyes, porphyrin-based dyes, perylene-based dyes, indigo-based dyes, and naphthalocyanine-based dyes. Generally, the absorption coefficient of an organic dye is larger than the absorption coefficient of a metal complex dye in such a form that a molecule is coordinated to a transition metal.

A metal complex dye is composed of a metal and a molecule coordinated thereto. Examples of the molecule include porphyrin-based dyes, phthalocyanine-based dyes, naphthalocyanine-based dyes, and ruthenium-based dyes. The metal may be, for example, at least one selected from the group consisting of Cu, Ni, Fe, Co, V, Sn, Si, Ti, Ge, Cr, Zn, Ru, Mg, Al, Pb, Mn, In, Mo, Y, Zr, Nb, Sb, La, W, Pt, Ta, Ir, Pd, Os, Ga, Tb, Eu, Rb, Bi, Se, As, Sc, Ag, Cd, Hf, Re, Au, Ac, Tc, Te, and Rh. The metal complex dye used is preferably a dye in which a metal is coordinated to a phthalocyanine-based dye or a ruthenium-based dye and is particularly preferably a ruthenium-based metal complex dye.

The ruthenium-based metal complex dye used may be one of commercial ruthenium-based metal complex dyes such as Ruthenium 535 dye, Ruthenium 535-bis TBA dye, and Ruthenium 620-1H3 TBA dye which are trade names and manufactured by Solaronix.

A coadsorbent may be supported on the porous semiconductor layer 18a. The coadsorbent prevents association and aggregation of the sensitizing dye and allows the sensitizing dye to disperse in the porous semiconductor layer 18a. The coadsorbent may be selected from materials commonly used in this field according to the sensitizing dye to be used in combination.

The porous insulating layer 22 may be formed of, for example, at least one selected from the group consisting of titanium oxide, niobium oxide, zirconium oxide, silicon oxides such as silica glass and soda-lime glass, aluminum oxide, and barium titanate. Preferably, rutile-type titanium oxide is used for the porous insulating layer 22. When rutile-type titanium oxide is used for the porous insulating layer 22, the average particle diameter of the rutile-type titanium oxide is preferably from 5 nm to 500 nm inclusive and more preferably from 10 nm to 300 nm inclusive.

The catalyst layer 24 may be formed of, for example, at least one selected from the group consisting of platinum, graphite, carbon black, Ketjen black, carbon nanotubes, graphene, and fullerenes.

The counter electrode 34 may be formed of the same material as the material of the transparent conductive layer 14 or may be formed of a non-light-transmitting material. The counter electrode 34 may be formed of, for example, a metal material containing at least one selected from the group consisting of titanium, tungsten, gold, silver, copper, aluminum, and nickel. The counter electrode 34 may be formed of a conductive carbon material such as carbon black or Ketjen black. When a conductive carbon material is used for the counter electrode 34, the counter electrode 34 may be formed integrally with the catalyst layer 24. The thickness of the counter electrode 34 is, for example, from 1 µm to 50 µm inclusive. The electrical resistance of the counter electrode 34 is preferably as low as possible and is preferably 40 Ω/square or less.

The DSC module 200 exemplified in Fig. 3 includes two or more DSCs 100 electrically connected in series and integrated into a package. The plurality of DCSs 100 share the light-transmitting substrate 12. The electrolytic solution (carrier transport layer) 42 in the DSCs 100 is separated by a first sealing member 45 in a hermetically sealed manner. The DSC module 200 as a whole is sealed with a sealing material (the first sealing member 45) that bonds and fixes the light-transmitting substrate 12 and the substrate 32 to each other.

The first sealing member 45 can be formed of, for example, a photocurable resin or a thermosetting resin. In other words, the first sealing material used may be, for example, a photocurable resin or a thermosetting resin. By curing the first sealing material, the first sealing member 45 is obtained.

It is not always necessary that the first sealing member 45 be in contact with both the substrate 32 and the light-transmitting substrate 12. As exemplified in Fig. 3, the sealing member 45 may be in contact with the transparent conductive layer 14 and the substrate 32 so long as the counter electrode 34 of each DSC is connected in series to the transparent conductive layer 14 (specifically, the second transparent conductive layer 14b) of its corresponding adjacent DSC.

The substrate 32 may be formed of a material that can seal the electrolytic solution 42 and can prevent penetration of water etc. from the outside. The substrate 32 may be transparent or may not be transparent. However, when the DSC module 200 is used in an environment in which light enters also from the substrate 32 side, it is preferable that the substrate 32 is also transparent in order to increase the amount of light reaching the photosensitizer. When durability is required, it is preferable that a material having high mechanical strength such as tempered glass is used for the substrate 32. The thickness of the substrate 32 is, for example, from 0.1 mm to 5.0 mm inclusive.

No particular limitation is imposed on the electrolytic solution 42, so long as it is a liquid material (liquid) containing a redox couple and can be used for general cells, solar cells, etc. Specifically, the electrolytic solution 42 may be a liquid composed of a redox couple and a solvent that can dissolve the redox couple, a liquid composed of a redox couple and a molten salt that can dissolve the redox couple, or a liquid composed of a redox couple and a combination of a solvent and a molten salt that can dissolve the redox couple.

The redox couple may be, for example, an I⁻/I³⁻-based, Br²⁻/Br³⁻-based, Fe²⁺/Fe³⁺-based, or quinone/hydroquinone-based redox couple. More specifically, the redox couple may be a combination of iodine (I₂) and a metal iodide such as lithium iodide (LiI), sodium iodide (NaI), potassium iodide (KI), or calcium iodide (CaI₂). The redox couple may be a combination of iodine and a tetraalkyl ammonium salt such as tetraethylammonium iodide (TEAI), tetrapropylammonium iodide (TPAI), tetrabutylammonium iodide (TBAI), or tetrahexylammonium iodide (THAI). The redox couple may be a combination of bromine and a metal bromide such as lithium bromide (LiBr), sodium bromide (NaBr), potassium bromide (KBr), or calcium bromide (CaBr₂). Preferably, the redox couple used is a combination of LiI and I₂.

Preferably, the solvent for the redox couple is, for example, a solvent containing at least one selected from the group consisting of carbonate compounds such as propylene carbonate, nitrile compounds such as acetonitrile, alcohols such as ethanol, water, and aprotic polar materials. More preferably, a carbonate compound or a nitrile compound is used alone, or a mixture thereof is used as the solvent.

Fig. 4 schematically shows a cross section of the DSC module 200 with non-sealed injection holes 51, the cross section being parallel to a principal surface (not shown) of the transparent substrate 12 (the cross section being parallel to the xy plane). The cross section includes the injection holes 51. Fig. 5 is a side view schematically showing a side surface of a DSC 100 with an injection hole 51 (opening 50) sealed with a second sealing member 52, the side surface being viewed in the x-axis direction.

The DSCs 100 (the electrolytic solution 42 in the DSCs 100) are separated from each other by the first sealing member 45. The first sealing member 45 forms, between the transparent substrate 12 and the substrate 32, spaces S to be filled with the electrolytic solution 42. Each of the spaces S includes an injection hole 51 having an opening 50 for injecting the electrolytic solution 42. Sealing materials widely used for solar cells can be used as the material (first sealing material) of the first sealing member 45. The first sealing material used may be, for example, a photocurable resin (typically an ultraviolet curable resin) or a thermosetting resin. Preferably, the first sealing material used is a thermosetting resin. When a thermosetting resin is used, the reliability of the DSCs 100 at high temperature and high humidity is improved. When a thermosetting resin is used as the first sealing material, erosion of the first sealing member 45 by the electrolytic solution 42 can be prevented, and high adhesion is obtained between the transparent substrate 12 and the first sealing member 45 and between the substrate 32 and the first sealing member 45. The thermosetting resin used may be an epoxy resin, a phenolic resin, a melamine resin, etc. In particular, when the first sealing material used is an epoxy resin, the spread of the epoxy resin is small during application of the first sealing material to the substrate 32 in a multiple DSC production process for producing a plurality of DSCs from one substrate 32, and the yield is thereby improved.

As shown in Fig. 5, the second sealing members 52 seal the injection holes 51 to thereby hermetically seal the spaces S. When the DSC module 200 is viewed from its side surface, it is only necessary that each opening 50 be provided in at least part of the first sealing member 45. For example, each opening 50 may be provided so as to be in contact with at least one of the transparent substrate 12 and the substrate 32. The shape of the openings 50 is not limited to the rectangular shape illustrated and may be circular or elliptic. Sealing materials widely used for solar cells can be used as the material (second sealing material) of the second sealing members 52, as in the case of the first sealing material. The second sealing material used may be, for example, a photocurable resin (typically an ultraviolet curable resin) or a thermosetting resin. In Fig. 5, the length of the opening 50 in the y direction is, for example, 1 mm and its length in the z direction is, for example, 70 µm.

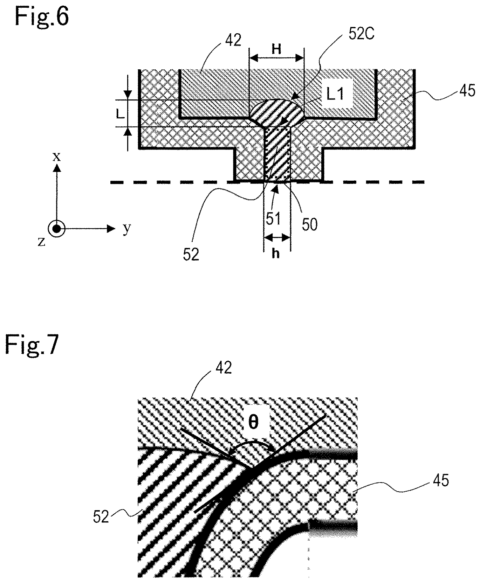

Fig. 6 schematically shows a cross section of the DSC module 200 with an injection hole 51 sealed with a second sealing member 52, the cross section being parallel to the principal surface (not shown) of the transparent substrate 12 (the cross section being parallel to the xy plane). In the cross section, the shape of the injection hole 51 in the present embodiment is rectangular (a portion indicated by a broken line in the figure). The second sealing member 52 extends beyond a first one (side L1) of opposite sides of the rectangular shape and reaches the electrolytic solution 42, a second one of the opposite sides corresponding to the opening 50. Typically, each second sealing member 52 has, at its apex, a convex shape 52C protruding toward the electrolytic solution 42 and has an overall shape similar to a cross section of a mushroom. However, the boundary between the second sealing member 52 and the electrolytic solution 42 may not be a curved line. For example, the boundary between the second sealing member 52 and the electrolytic solution 42 may include a linear shape.

In the cross section parallel to the principal surface (not shown) of the transparent substrate 12 and including the injection hole 51, a distance H is larger than the width h of the opening 50 of the injection hole 51, where the distance H is the distance between two contact points at which the first sealing member 45, the second sealing member 52, and the electrolytic solution 42 are in contact with each other. A straight line connecting the two contact points is substantially parallel to sides of the opening 50. The phrase "substantially parallel" means that the angle between the straight line and the sides of the opening 50 is from 0° to 10° inclusive.

The two contact points in the cross section correspond to points on a three-phase boundary between the first sealing member 45, the second sealing member 52, and the electrolytic solution 42 in a three-dimensional module structure. In the present description, the distance H between the two contact points may be referred to as the width H of the second sealing member 52 on the electrolytic solution 42 side. With this shape of the second sealing member 52, as the internal pressure of the DSC 100 increases, a force that causes the second sealing member 52 to adhere intimately to the first sealing member 45 increases, so leakage of the electrolytic solution 42 can be prevented. In this case, it is preferable that the first sealing material is a thermosetting resin. The hardness of a cured thermosetting resin is higher than the hardness of a cured photocurable resin. Therefore, when the first sealing material is a thermosetting resin, the first sealing member 45 resists deformation, and dissipation of the internal pressure of the space S can be prevent, so that the force causing the second sealing member 52 to adhere intimately to the first sealing member increases. Therefore, the leakage of the electrolytic solution 42 can be readily prevented when the first sealing material used is a thermosetting resin. Moreover, it is preferable that the first sealing material is a thermosetting resin and the second sealing material is a photocurable resin. In this case, the internal pressure of the space S causes the second sealing member 52 having a lower hardness than the first sealing member 45 to be selectively deformed. The second sealing member 52 is deformed such that a gap between the first sealing member 45 and the second sealing member 52 is filled. Therefore, in the embodiment in which a thermosetting resin is used as the first sealing material and a photocurable resin is used as the second sealing material, the force causing the second sealing member 52 to adhere intimately to the first sealing member 45 is stronger, so that the leakage of the electrolytic solution 42 can be further prevented. Specifically, it is preferable to combine an epoxy resin used as the first sealing material with an acrylic resin used as the second sealing material.

When the apex of each second sealing member 52 has the convex shape 52C, it is preferable that the relations H/h ≥ 1.68 and 0.83 ≥ h/L hold, where L is the distance from the apex of the convex shape 52C to the side L1 of the rectangular shape of the injection hole 51, as shown in Fig. 6. The apex is a point which is on the convex curve at the boundary between the second sealing member 52 and the electrolytic solution 42 and at which the perpendicular from the point to the side L1 is longest. The distance L corresponds to the length of the perpendicular from the apex to the side L1.

Fig. 7 is an enlarged schematic illustration of the right one of the two contact points in the cross section in Fig. 6. As illustrated in the cross section, it is preferable that the angle θ between the first sealing member 45 and the second sealing member 52 at each of the two contact point is 90° or more and less than 180°.

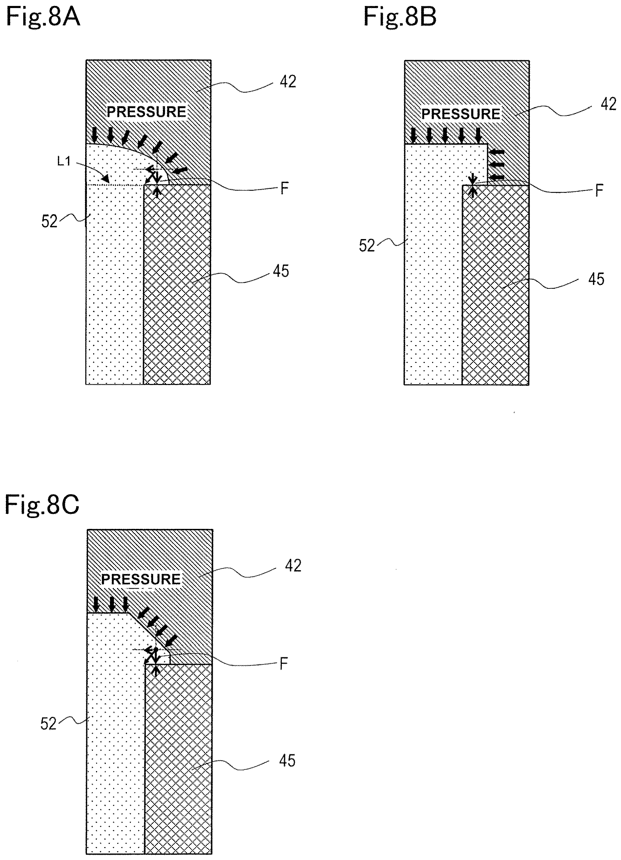

Fig. 8A schematically shows how the internal pressure of the electrolytic solution 42 acts on the convex shape 52C. As the vapor pressure of the electrolytic solution 42 increases, a component F of the internal pressure in a direction perpendicular to the side L1 (or a surface of the first sealing member 45 on the space S side) presses the second sealing member 52 against the first sealing member 45, and peeling at the interface is thereby prevented. The higher the temperature of the electrolytic solution 42, i.e., the higher the vapor pressure of the electrolytic solution 42, the higher the internal pressure, so that the force acting on the interface between the first sealing member 45 and the second sealing member 52 (the component F of the internal pressure) further increases. Therefore, the peeling at the interface can be further prevented.

Fig. 8B schematically shows how the internal pressure of the electrolytic solution 42 acts on the apex of the second sealing member 52 when the apex has a rectangular shape in the cross section. Fig. 8C schematically shows how the internal pressure of the electrolytic solution 42 acts on the apex of the second sealing member 52 when the apex has an inclination in the cross section.

As described above, the shape of the apex of the second sealing member 52 is not limited to the convex shape, and, for example, the shapes shown in Figs. 8B and 8C may be used. With any of these shapes, the higher the temperature of the electrolytic solution 42, i.e., the higher the vapor pressure of the electrolytic solution 42, the higher the internal pressure, so that the force acting on the interface between the first sealing member 45 and the second sealing member 52 (the component F of the internal pressure) further increases. Therefore, the peeling at the interface can be further prevented.

### [Method for manufacturing DSC module 200]

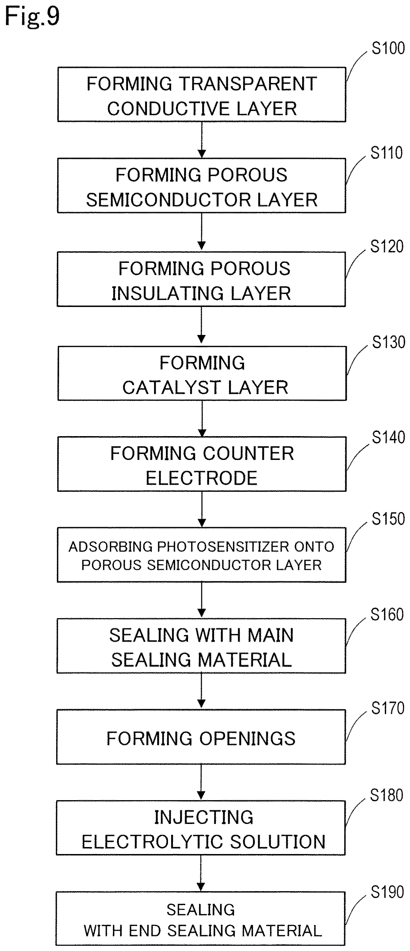

Next, an example of a method for manufacturing the DSC module 200 will be described with reference to Fig. 9.

Fig. 9 shows a flowchart of the example of the method for manufacturing the DSC module 200. The manufacturing method typically includes 10 steps (steps S100 to S190). Of course, the method may include other steps.

First, the transparent substrate 12 having the transparent conductive layer 14 formed thereon is provided (step S100). For example, the transparent substrate 12 is prepared, and the transparent conductive layer 14 may be formed on the transparent substrate 12. To form the transparent conductive layer 14, a sputtering method or a spray method, for example, may be used. There is a supplier who supplies a substrate including the transparent substrate 12 and the transparent conductive layer 14 formed thereon. Therefore, such a substrate supplied may be used. The transparent substrate 12 used may be, for example, a transparent substrate manufactured by Nippon Sheet Glass Co., Ltd.

Next, the porous semiconductor layer 18a is formed on the transparent conductive layer 14 (step S110). To form the porous semiconductor layer 18a, any of various widely known techniques can be used. For example, a suspension containing the above-described fine semiconductor particles is applied to the transparent conductive layer 14 and subjected to at least one of drying and firing. In this manner, the porous semiconductor layer 18a can be formed.

More specifically, first, the fine semiconductor particles are dispersed in an appropriate solvent to obtain a suspension. Examples of the solvent that can be used include: glyme-based solvents such as ethylene glycol monomethyl ether; alcohols such as isopropyl alcohol; alcohol-based solvent mixtures such as isopropyl alcohol/toluene; and water. Instead of the suspension, a commercial titanium oxide paste (e.g., Ti-nanoxide, T, D, T/SP, D/SP manufactured by Solaronix) may be used.

The suspension obtained is applied to the transparent conductive layer 14 and subjected to at least one of drying and firing, and the porous semiconductor layer 18a can thereby be formed. To apply the suspension, a method such as a doctor blade method, a squeegee method, a spin coating method, or a screen printing method may be used.

The conditions of drying and firing of the suspension, such as temperature, time, and atmosphere, may be appropriately set according to the type of the fine semiconductor particles. For example, the suspension can be dried and fired by holding it in an air atmosphere or an inert gas atmosphere in a temperature range of from 50°C to 800°C inclusive for 10 seconds or longer and 12 hours or shorter. The suspension may be dried and fired once at a single temperature or twice or more at different temperatures.

The porous semiconductor layer 18a may have a layered structure. In this case, suspensions of fine semiconductor particles of different types are prepared. Then each of these suspensions is applied and subjected to at least one of drying and firing, and the porous semiconductor layer 18a can thereby be formed.

After the formation of the porous semiconductor layer 18a, aftertreatment may be performed for the purpose of improving performance such as improvement in electric connection between the fine semiconductor particles, an increase in the surface area of the porous semiconductor layer 18a, and a reduction in defect levels of the fine semiconductor particles. For example, when the porous semiconductor layer 18a is formed of titanium oxide, the performance of the porous semiconductor layer 18a can be improved by subjecting it to aftertreatment using an aqueous titanium tetrachloride solution.

Next, the porous insulating layer 22 is formed on the porous semiconductor layer 18a (step S120). The porous insulating layer 22 can be formed, for example, by the same method as the above-described method for forming the porous semiconductor layer 18a. For example, an insulating material in the form of fine particles is dispersed in a solvent and mixed with a macromolecular compound such as ethyl cellulose or polyethylene glycol (PEG) to produce a paste. The paste is applied to the surface of the porous semiconductor layer 18a and subjected to at least one of drying and firing, and the porous insulating layer 22 can thereby be formed.

Next, the catalyst layer 24 is formed on the porous insulating layer 22 (step S130). The catalyst layer 24 can be formed using any of various widely used methods. For example, when platinum is used for the catalyst layer 24, the catalyst layer 24 can be formed using a method such as a sputtering method, thermal decomposition of chloroplatinic acid, or electrodeposition. When carbon such as graphite, carbon black, Ketjen black, carbon nanotubes, graphene, or fullerenes is used for the catalyst layer 24, the catalyst layer 24 can be formed on the porous insulating layer 22 by, for example, applying a paste prepared by dispersing the carbon in a solvent using, for example, a screen printing method.

Next, the counter electrode 34 is formed so as to cover the catalyst layer 24, the porous insulating layer 22, and the transparent conductive layer 14 (step S140). The counter electrode 34 can be formed using, for example, a sputtering method, a spray method, or a screen printing method. When a conductive carbon material is used for the counter electrode 34, the step of forming the catalyst layer 24 may be omitted.

Next, for example, a sensitizing dye used as a photosensitizer is adsorbed onto the porous semiconductor layer 18a (step S150). In this manner, the porous semiconductor layer 18a supporting the sensitizing dye, i.e., the photoelectric conversion layer 18, is obtained.

To allow the sensitizing dye to firmly adsorb onto the porous semiconductor layer 18a, it is preferable that the sensitizing dye used has, in its molecule, an interlocking group such as a carboxyl group, an alkoxy group, a hydroxyl group, a sulfonic acid group, an ester group, a mercapto group, or a phosphonyl group. Generally, the interlocking group is a functional group which, when the sensitizing dye is fixed to the porous semiconductor layer 18a, is interposed therebetween and provides electrical connection that facilitates electron transfer between the sensitizing dye in an excited state and the conduction band of the semiconductor.

The sensitizing dye can be adsorbed onto the porous semiconductor layer 18a using, for example, a method including immersing the porous semiconductor layer 18a in a dye adsorption solution containing the sensitizing dye dissolved therein. When the porous semiconductor layer 18a is immersed in the dye adsorption solution containing the sensitizing dye dissolved therein, the dye adsorption solution may be heated, stirred, or circulated in order to allow the dye adsorption solution to penetrate deep into the pores of the porous semiconductor layer 18a.

The solvent used to dissolve the sensitizing dye may be any solvent that can dissolve the sensitizing dye, and, for example, at least one selected from the group consisting of alcohols, toluene, acetonitrile, tetrahydrofuran (THF), chloroform, and dimethylformamide may be used. It is preferable that the solvent used to dissolve the sensitizing dye is purified, and a mixture of two or more solvents may be used.

The concentration of the sensitizing dye in the dye adsorption solution may be appropriately set according to the types of the sensitizing dye and solvent used and the conditions of the adsorption process. To improve the adsorption capability, it is preferable that the concentration of the dye adsorption solution is high, and the concentration is preferably, for example, 1×10⁻⁵ mol/L or more. When the dye adsorption solution is prepared, the dye adsorption solution may be heated in order to improve the solubility of the sensitizing dye.

Next, the transparent substrate 12 is laminated onto the substrate 32 with the first sealing material, and then the first sealing material is cured to thereby form the spaces S to be filled with the electrolytic solution 42 (step S160). The first sealing material is, for example, an ultraviolet curable resin or a thermosetting resin. By curing the first sealing material, the first sealing member 45 is obtained. Specifically, for example, a dispenser manufactured by Musashi Engineering, Inc. is used to apply the first sealing material to the transparent substrate 12. In this case, portions uncoated with the first sealing material are provided in the transparent substrate 12, and at least one injection hole 51 is formed for each cell, the injection holes 51 being provided on the same edge of the transparent substrate 12. Then the substrate 32 is laminated onto the transparent substrate 12, and the first sealing material is cured. The substrate 32 used may be, for example, non-alkali glass manufactured by Nippon Sheet Glass Co., Ltd.

When the first sealing material used is an ultraviolet curable resin, TB3035B manufactured by ThreeBond Co., Ltd., for example, may be used.

Next, the injection holes 51 having openings 50 for injecting the electrolytic solution 42 into the spaces S are formed (step S170). With the substrate 32 laminated onto the transparent substrate 12, the pair of substrates are cut using, for example, a glass cutter at the positions of the ends of the plurality of injection holes 51 formed on the same edge of the transparent substrate 12 such that, when the DSC module 200 is viewed in a direction normal to the principal surface (not shown) of the transparent substrate 12 (e.g., the z axis direction in Fig. 6), the edge of the transparent substrate 12, the edge of the substrate 32, and sides of the openings 50 are aligned with each other. Therefore, when the DSC module 200 is viewed in the direction normal thereto, the edges of the substrates and the sides of the openings 50 are aligned with each other.

Next, the spaces S are evacuated to a pressure in the range of from 200 Pa to 5,000 Pa in a vacuum chamber. Then the electrolytic solution 42 is brought into contact with the openings 50, and the vacuum chamber is opened to atmosphere to thereby inject the electrolytic solution 42 into the spaces S (step S180). Specifically, a pre-module to be evacuated and a container containing the electrolytic solution 42 are placed in the vacuum chamber such that the openings 50 of the injection holes 51 face vertically downward. In the present description, an intermediate product during manufacturing of the DSC module 200 may be referred to as the "pre-module." The spaces S of the pre-module are evacuated to a pressure in the range of from 200 Pa to 5,000 Pa in the vacuum chamber. Preferably, the vacuum chamber is evacuated to 3,000 Pa to thereby evacuate the spaces S of the pre-module. Then the openings 50 of the injection holes 51 are brought into contact with the electrolytic solution 42 in the container, and the chamber is opened to atmosphere to inject the electrolytic solution 42 into the spaces S.

Next, after injection of the electrolytic solution 42 into the spaces S, the second sealing material is provided to the injection holes 51, and the pre-module is left to stand in a thermostatic chamber at a temperature in the range of from - 40°C to 0°C inclusive for a prescribed time to draw the second sealing material to the electrolytic solution 42 side of the injection holes. After completion of drawing of the second sealing material, the second sealing material is cured in the thermostatic chamber to thereby hermetically seal the spaces S (step S190). For example, an ultraviolet lamp is placed in an upper portion of the thermostatic chamber, and the ultraviolet lamp is used to irradiate the second sealing material with ultraviolet light. Alternatively, for example, an ultraviolet irradiation device having an irradiation head into which light is introduced through an optical fiber may be used. In this case, with a door of the thermostatic chamber opened, the second sealing material can be irradiated with ultraviolet light from the irradiation head. Specifically, for example, KimWipes (registered trademark) impregnated with acetone are used to wipe the injection holes 51, and then a dispenser is used to apply the second sealing material to the injection holes 51. Then the pre-module is left to stand in the thermostatic chamber at a temperature in the range of from - 40°C to 0°C inclusive for a prescribed time to draw the second sealing material to the electrolytic solution 42 side of the injection holes 51. It is preferable that the second sealing material is drawn until, for example, the shape of the sealing material shown in Fig. 6 is obtained. The prescribed time is, for example, from 1 minute to 10 minutes inclusive. After completion of drawing of the second sealing material, the second sealing material is cured in the low-temperature thermostatic chamber to hermetically seal the spaces S.

The second sealing material used may be, for example, an ultraviolet curable resin (TB3035B, ThreeBond Co., Ltd.). In this case, it is preferable that the pre-module is left to stand in the thermostatic chamber, for example, at -20°C for 10 minutes. The shape of the second sealing material shown in Fig. 6 can thereby be obtained. After completion of drawing of the second sealing material, the ultraviolet curable resin is irradiated with ultraviolet (UV) light within the thermostatic chamber to cure the ultraviolet curable resin, and the spaces S are thereby hermetically sealed. The second sealing material is cured in the same manner as for the first sealing material to thereby obtain the second sealing members 52.

The DSC module 200 can be obtained through the above-described steps.

In the DSC module 200 in the present embodiment, the leakage of the electrolytic solution 42 at the interfaces between the first sealing member 45 and the second sealing members 52 can be prevented even in an environment in which the temperature of the DSCs (cells) 100 increases. Therefore, the DSC module 200 can be used in, for example, an internal lighting signboard in which an increase in temperature caused by fluorescent lamps or LEDs (Light Emitting Diodes) serving as heat sources is highly assumed to occur.

### (Embodiment 2)

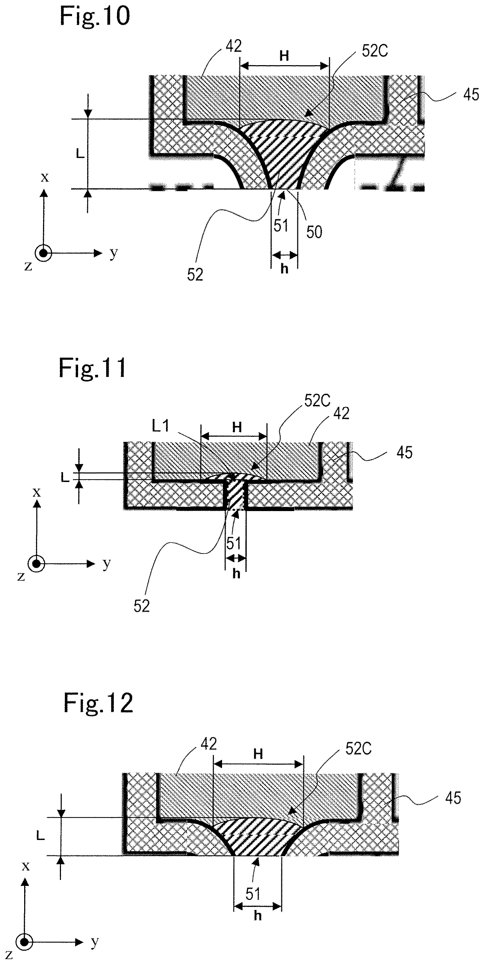

Fig. 10 schematically shows a cross section of a DSC module 200 in the present embodiment with an injection hole 51 filled with a second sealing member 52, the cross section being parallel to the principal surface (not shown) of the transparent substrate 12 (the cross section being parallel to the xy plane).

In the cross section parallel to the principal surface (not shown) of the transparent substrate 12 and including the injection hole 51, a distance H is larger than the width h of the opening 50 of the injection hole 51, where the distance H is the distance between two contact points at which the first sealing member 45, the second sealing member 52, and the electrolytic solution 42 are in contact with each other. In the cross section, the angle θ between the first sealing member 45 and the second sealing member 52 at each of the two contact points is preferably from 90° to 180° inclusive. The second sealing member 52 has an apex having the convex shape 52C protruding toward the electrolytic solution 42. These are common to embodiments 1.

In contrast to embodiment 1, the width of the injection hole 51 in the present embodiment increases as the distance from the opening 50 increases. In other words, the width of the injection hole 51 continuously changes so as to increase from the opening 50 toward the electrolytic solution 42. In this structure, as the internal pressure of the DSC 100 increases, a force that causes the second sealing member 52 to adhere intimately to the first sealing member 45 increases. Moreover, since the width of the injection hole 51 changes continuously as described above, the shear stress generated at the interface between the first sealing member 45 and the second sealing member 52 can be dispersed. Therefore, a fastening effect is obtained over the entire interface.

In the injection hole 51 in the cross section described above, it is preferable that the boundary (interface) between the first sealing member 45 and the second sealing member 52 has a rounded shape. In other words, it is preferable that a portion of the first sealing member 45 that forms the injection hole 51 is formed so as to have a rounded shape. The radius of curvature R is, for example, from 0.5 mm to 5.0 mm inclusive. Preferably, on the boundary between the first sealing member 45 and the second sealing member 52, at least a portion that receives a force that prevents leakage of the electrolytic solution 42 when the internal pressure of the DSC 100 increases has a rounded shape.

As illustrated, it is preferable that the relations H/h ≥ 1.68 and 0.83 ≥ h/L hold, where L is the distance from the apex of the convex shape 52C to the opening 50. The apex is a point which is on the convex curve at the boundary between the second sealing member 52 and the electrolytic solution 42 and at which the perpendicular from the point to an edge of the opening 50 is longest. The distance L corresponds the length of the perpendicular from the apex to the edge of the opening. The boundary between the first sealing member 45 and the second sealing member 52 includes a portion that receives the force that prevents peeling at the interface when the internal pressure of the DSC 100 increases. When the length L is a prescribed value, the length of the above portion of the boundary can be larger when the portion of the first sealing member 45 that forms the injection hole 51 has a rounded shape than when this portion of the first sealing member 45 has a straight shape (embodiment 1). Therefore, the peeling at the interface can be prevented more effectively.

In the present embodiment, the leakage of the electrolytic solution 42 at the interface between the first sealing member 45 and the second sealing member 52 can be prevented even in an environment in which the temperature of the DSC (cell) 100 increases. Moreover, while the length of the interface is increased, a space corresponding to a portion of the injection hole 51 that protrudes outward from the first sealing member 45 when the DSC 100 is viewed in a direction normal to the principal surface of the transparent substrate 12 (this space is referred to as a dead space not contributing to power generation) can be reduced, so that the cell size of the DSC 100 can be reduced. Moreover, since the width of the injection hole 51 changes continuously as described above, the electrolytic solution 42 is prevented from entering abruptly the space S during injection of the electrolytic solution 42. Therefore, the DSC 100 can resist breakage, and the yield is improved.

### (Embodiment 3)

A DSC module 200 in the present embodiment differs from the DSC modules 200 in embodiments 1 and 2 in that the DSC module 200 in the present embodiment does not have the dead space described above.

Figs. 11 and 12 schematically show cross sections of DSC modules 200 in the present embodiment with injection holes 51 sealed with second sealing members 52, the cross sections being parallel to the principal surface (not shown) of the transparent substrate 12 (the cross sections being parallel to the xy plane). The structure in Fig. 11 corresponds to a structure in which the dead space in the module structure shown in Fig. 6 is eliminated, and the structure in Fig. 12 corresponds to a structure in which the dead space in the module structure shown in Fig. 10 is eliminated. The dead space will be described again. The dead space corresponds to a portion of the injection hole 51 that protrudes outward from the first sealing member 45 when the DSC 100 is viewed in a direction normal to the principal surface of the transparent substrate 12, and this portion does not contribute to power generation. The width H of each second sealing member 52 on the electrolytic solution 42 side, the length L, and the width of each opening 50 are as defined above.

In the present embodiment, the leakage of the electrolytic solution 42 at the interfaces between the first sealing member 45 and the second sealing members 52 can be prevented even in an environment in which the temperature of the DSCs (cells) 100 increases. Since no dead spaces are provided in the DSC module 200, the cell size of each DSC 100 can be reduced.

### (Embodiment 4)

A DSC module 300 in the present embodiment differs from the DSC modules 200 in embodiments 1 to 3 in that an integrally formed second sealing material 52 seals injection holes 51 of two dye-sensitized solar cells of the plurality of dye-sensitized solar cells 100.

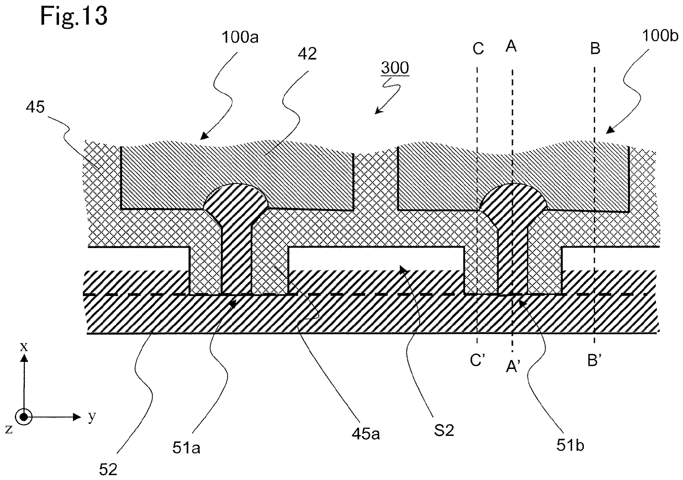

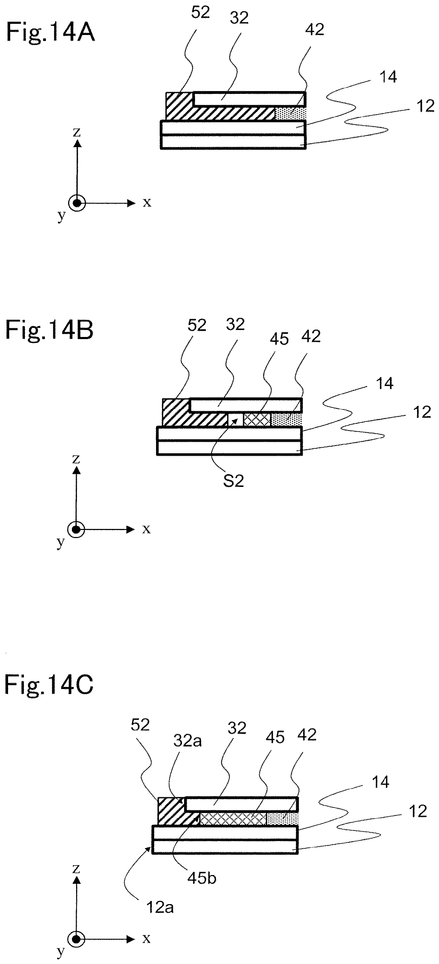

Fig. 13 schematically shows a cross section of the DSC module 300 in the present embodiment near injection holes 51a and 51b of two dye-sensitized solar cells 100a and 100b of the plurality of dye-sensitized solar cells 100 with the injection holes 51a and 51b sealed with the second sealing material, the cross section being parallel to the principal surface (not shown) of the transparent substrate 12 (the cross section being parallel to the xy plane). Fig. 14A schematically shows a cross section (a cross section parallel to the xz plane) of the DSC module 300 taken along broken line AA' in Fig. 13. Fig. 14B schematically shows a cross section (a cross section parallel to the xz plane) of the DSC module 300 taken along broken line BB' in Fig. 13. Fig. 14C schematically shows a cross section (a cross section parallel to the xz plane) of the DSC module 300 taken along broken line CC' in Fig. 13.

As shown in Fig. 13, in the DSC module 300 in the present embodiment, the single integrated (continuous) second sealing member 52 seals the injection holes 51a and 51b of the two dye-sensitized solar cells 100a and 100b of the plurality of dye-sensitized solar cells 100.

The dye-sensitized solar cells 100a and 100b are adjacent to each other, and their adjacent portions share the same portion of the first sealing member 45. The photoelectrodes 15 of the dye-sensitized solar cells 100a and 100b are formed on the same transparent substrate 12, and the dye-sensitized solar cells 100a and 100b share the transparent substrate 12 and the substrate 32.

The first sealing member 45 forming the injection holes 51a and 51b includes extending portions 45a protruding outward near openings 51. The second sealing member 52 seals a space S2 formed by an outer wall of each of the extending portions 45a, an outer wall of the first sealing member 45, the transparent substrate 12, and the substrate 32. As shown in Fig. 14B, the space S2 may not be fully sealed with the second sealing member 52, and part of the space S2 may remain present between the outer wall of the first sealing member 45 and the second sealing member 52.

In the above structure, even when the internal pressure of the dye-sensitized solar cells 100a and 100b increases and a force is applied to the second sealing member 52 in a direction in which the second sealing member 52 comes off the injection holes 51a and 51b, the force acts in a direction in which the second sealing member 52 supports the first sealing member 45, so that the resistance to leakage of the electrolytic solution 42 can be further improved.

In the above structure, the step of removing the electrolytic solution 42 that has adhered to outer walls of the first sealing member 45 when the electrolytic solution 42 is injected into the spaces S can be omitted or simplified.

As shown in Fig. 14C, in the DSC module 300 in the present embodiment, the distance from an edge 12a of the transparent substrate 12 to an edge 45b (the opening 50) of each injection hole 51 is longer than the distance from an edge 32a of the substrate 32 to the edge 45b. In another embodiment, the distance from the edge 12a to the edge 45b may be shorter than the distance from the edge 32a to the edge 45b.

In the above structure, the area of contact between the second sealing member 52 and the transparent substrate 12 can be increased. Therefore, the force applied from the second sealing member 52 to the transparent substrate 12 increases, and the frictional force on the contact surface between the second sealing member 52 and the transparent substrate 12 can be improved.

### (EXAMPLES)

The inventors evaluated the occurrence of leakage of the electrolytic solution (durability) in Examples (1 to 8) and Comparative Examples (1 and 2). Specifically, the occurrence of leakage of the electrolytic solution after a DSC module was left to stand in an environment at 40°C for 1,000 hours was evaluated, and the number of days until leakage of the electrolytic solution occurred when a DSC module was left to stand in an environment at 80°C was also evaluated. In the Examples and Comparative Examples, an ultraviolet curable resin (TB3035B manufactured by ThreeBond Co., Ltd.) was used as the first sealing material and the second sealing material. The following curing conditions, for example, were used: an ultraviolet light source (metal halide lamp manufactured by Joyo Engineering Co.Ltd.), an intensity of 4,000 mW/cm² @365 nm, an irradiation time for the first sealing material of 1 second or longer and 120 seconds or shorter (10 kJ/m² or more and 50 kJ/m² or less), and an irradiation time for the second sealing material of 1 second or longer and 120 seconds or shorter (10 kJ/m² or more and 50 kJ/m² or less).

The Examples will be described in detail.
(1) Example 1 corresponds to the DSC module 200 in embodiment 1 shown in Fig. 6. The width H of the second sealing member 52 is 2.1 mm, and the width h of the opening is 1.3 mm. The length L is 1.2 mm.
(2) Example 2 corresponds to the DSC module 200 in embodiment 1 shown in Fig. 6. The width H of the second sealing member 52 is 2.6 mm, and the width h of the opening is 1.2 mm. The length L is 0.6 mm.
(3) Example 3 corresponds to the DSC module 200 in embodiment 1 shown in Fig. 6. The width H of the second sealing member 52 is 4.3 mm, and the width h of the opening is 1.2 mm. The length L is 2.9 mm.
(4) Example 4 corresponds to the DSC module 200 in embodiment 1 shown in Fig. 6. The width H of the second sealing member 52 is 3.2 mm, and the width h of the opening is 1.5 mm. The length L is 1.7 mm.
(5) Example 5 corresponds to the DSC module 200 in embodiment 2 shown in Fig. 10. The width H of the second sealing member 52 is 3.2 mm, and the width h of the opening is 1.9 mm. The length L is 2.8 mm.
(6) Example 6 corresponds to the DSC module 200 in embodiment 2 shown in Fig. 10. The width H of the second sealing member 52 is 3.3 mm, and the width h of the opening is 2.5 mm. The length L is 0.9 mm.
(7) Example 7 corresponds to the DSC module 200 in embodiment 2 shown in Fig. 10. The width H of the second sealing member 52 is 2.1 mm, and the width h of the opening is 1.1 mm. The length L is 0.8 mm.
(8) Example 8 corresponds to the DSC module 200 in embodiment 2 shown in Fig. 10. The width H of the second sealing member 52 is 1.8 mm, and the width h of the opening is 0.8 mm. The length L is 0.9 mm.
(9) Example 9 corresponds to the DSC module 200 in embodiment 2 shown in Fig. 10. The width H of the second sealing member 52 is 2.2 mm, and the width h of the opening is 2.1 mm. The length L is 1.1 mm.

The Comparative Example will next be described in detail.

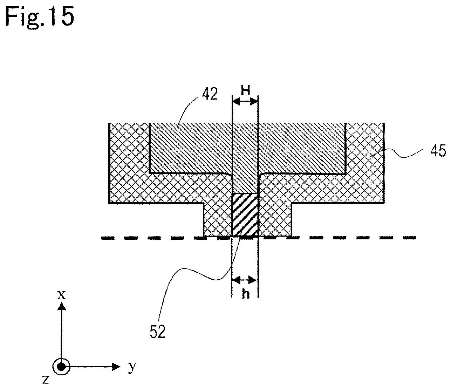

Fig. 15 schematically shows a cross section of a DSC module in the Comparative Example with an injection hole 51 sealed with a second sealing member 52, the cross section being parallel to the principal surface (not shown) of the transparent substrate 12 (the cross section being parallel to the xy plane). As illustrated, the width H of the second sealing member 52 is substantially the same as the width h of the opening. The second sealing member 52 as a whole has a rectangular shape. Specifically, in Comparative Example 1, the width H of the second sealing member 52 is 1.0 mm, and the width h of the opening is 1.0 mm. The length L is 1.2 mm.

The evaluation results are shown in Table 1 below. Table 1 shows the values of H/h, h/L, and angle θ, the occurrence of leakage at 40°C after 1,000 hours, and the number of days until the occurrence of leakage of the electrolytic solution was found when a DSC module was left to stand at 80°C. In the Comparative Example (conventional example), the leakage of the electrolytic solution was found to occur. However, in the Examples, no leakage of the electrolytic solution was found. The occurrence of leakage of the electrolytic solution was determined as follows. The cell in each of the Examples and Comparative Example was observed under a magnifier, and the presence of a gap in a region sealed by the first sealing member 45 and the second sealing member 52 was checked.

**[Table 1]**

| | h/L | H/h | Angle θ° | Occurrence of leakage 40°C After 1,000 hours | Number of days until leakage was found during storage at 80°C |
|---|---|---|---|---|---|
| Example 1 | 1.08 | 1.62 | 118 | No | 28 |
| Example 2 | 2.00 | 2.17 | 138 | No | 28 |
| Example 3 | 0.41 | 3.58 | 132 | No | 49 |
| Example 4 | 0.83 | 2.13 | 125 | No | 42 |
| Example 5 | 0.68 | 1. 68 | 152 | No | 42 |
| Example 6 | 2.78 | 1.32 | 163 | No | 21 |
| Example 7 | 1.38 | 1.91 | 158 | No | 21 |
| Example 8 | 0.89 | 2.25 | 168 | No | 35 |
| Example 9 | 1.91 | 1.05 | 65 | No | 14 |
| Comparative Example 1 | 0.83 | 1.00 | 68 | Yes | 5 |

As can be seen from the results of the accelerated degradation test at 80°C, the results in Examples 3, 4, and 5 are better than the results in other Examples and Comparative Example 1. In Examples 3, 4, and 5, the relations H/h ≥ 1.68 and 0.83 ≥ h/L hold. Specifically, these results show that, when the cross-sectional shape of the second sealing members 52 satisfies these relations, the leakage of the electrolytic solution 42 at the interfaces between the first sealing member 45 and the second sealing members 52 can be more effectively prevented.

### Industrial Applicability

The dye-sensitized solar cell modules in the embodiments of the present invention can be preferably used as solar cell modules used at high temperature.

### [Incorporation by Reference]

The present application claims priority to Japanese Patent Application No. 2016-144417, filed July 22, 2016, the entire content of which is incorporated herein by reference. Reference Signs List

- 12:: transparent substrate
- 14:: transparent conductive layer
- 15:: photoelectrode
- 18:: photoelectric conversion layer
- 18a:: porous semiconductor layer
- 22:: porous insulating layer
- 24:: catalyst layer
- 32:: substrate
- 34:: counter electrode
- 42:: electrolytic solution
- 45:: first sealing member
- 50:: opening
- 51:: injection hole
- 52:: second sealing member
- 52C:: convex shape
- 100:: DSC
- 200,: 300: DSC module

## Claims

1. A dye-sensitized solar cell comprising:
a first light-transmitting substrate and a second substrate;
an electrolytic solution;
a first transparent conductive layer disposed on the first light-transmitting substrate and opposed to the electric solution;
a porous semiconductor layer disposed on the first transparent conductive layer and opposed to the second substrate;
a photosensitizer supported on the porous semiconductor layer;
a counter electrode provided between the porous semiconductor layer and the second substrate;
a first sealing member that forms a space between the first light-transmitting substrate and the second substrate, the space being filled with the electrolytic solution, the space including an injection hole that has an opening for injecting the electrolytic solution; and
a second sealing member that seals the injection hole to thereby hermetically seal the space,
wherein, in a cross section parallel to a principal surface of the first light-transmitting substrate and including the injection hole, a distance H is larger than a width h of the opening of the injection hole, where the distance H is a distance between two contact points at which the first sealing member, the second sealing member, and the electrolytic solution are in contact with each other.

2. The dye-sensitized solar cell according to claim 1,
wherein, in the cross section, an angle θ between the first sealing member and the second sealing member at each of the two contact points is 90° or more and less than 180°.

3. The dye-sensitized solar cell according to claim 1 or 2,
wherein, in the cross section, the injection hole has a rectangular shape.

4. The dye-sensitized solar cell according to claim 1 or 2,
wherein, in the cross section, a width of the injection hole increases as a distance from the opening increases.

5. The dye-sensitized solar cell according to claim 4,
wherein, in the injection hole in the cross section, a boundary between the first sealing member and the second sealing member has a rounded shape.

6. The dye-sensitized solar cell according to any of claims 1 to 5,
wherein, in the cross section, the second sealing member has a convex shape protruding toward the electrolytic solution.

7. The dye-sensitized solar cell according to claim 3,
wherein, in the cross section, the second sealing member has a convex shape protruding toward the electrolytic solution, and
wherein the relations H/h ≥ 1.68 and 0.83 ≥ h/L hold, where L is a distance from an apex of the convex shape to a first one of two opposite sides of the rectangular shape, a second one of the two opposite sides corresponding to the opening.

8. The dye-sensitized solar cell according to claim 5,
wherein, in the cross section, the second sealing member has a convex shape protruding toward the electrolytic solution, and
wherein the relations H/h ≥ 1.68 and 0.83 ≥ h/L hold, where L is a distance from an apex of the convex shape to the opening.

9. The dye-sensitized solar cell according to any of claims 1 to 8,
wherein, when the dye-sensitized solar cell is viewed in a direction normal to the principal surface, an edge of the first light-transmitting substrate, an edge of the second substrate, and the opening are aligned with each other.

10. The dye-sensitized solar cell according to any of claims 1 to 9, further comprising
a second transparent conductive layer that is disposed on the electrolytic solution side of the first light-transmitting substrate so as to be separated from the first transparent conductive layer, and
wherein the counter electrode is electrically connected to the second transparent conductive layer.

11. A dye-sensitized solar cell module comprising
a plurality of the dye-sensitized solar cells according to any of claims 1 to 10,
wherein the plurality of dye-sensitized solar cells are electrically connected in series or in parallel.

12. A dye-sensitized solar cell module comprising
a plurality of the dye-sensitized solar cells according to claim 10,
wherein the plurality of dye-sensitized solar cells include two dye-sensitized solar cells connected in series, and
wherein the first transparent conductive layer included in a first one of the two dye-sensitized solar cells is electrically connected to the second transparent conductive layer included in a second one of the two dye-sensitized solar cells.

13. A dye-sensitized solar cell module comprising
a plurality of the dye-sensitized solar cells according to claim 10,
wherein two adjacent dye-sensitized solar cells of the plurality of dye-sensitized solar cells share the first light-transmitting substrate, the second substrate, and the first sealing member,
the first sealing member including extending portions protruding outward,
the second sealing member further sealing a space defined by an outer wall of each of the extending portions, an outer wall of the first sealing member, the first light-transmitting substrate, and the second substrate.

14. The dye-sensitized solar cell module according to claim 13,
wherein a distance from an edge of a first one of the first light-transmitting substrate and the second substrate to the opening of each injection hole is longer than a distance from an edge of a second one of the first light-transmitting substrate and the second substrate to the opening of the each injection hole.

15. A method for manufacturing a dye-sensitized solar cell, the method comprising the steps of:
providing a first light-transmitting substrate including a transparent conductive layer formed thereon;
forming a porous semiconductor layer on the transparent conductive layer;
adsorbing a photosensitizer on the porous semiconductor layer;
forming a space to be filled with an electrolytic solution between the first substrate and a second substrate by laminating the first light-transmitting substrate onto the second substrate through a first sealing material and then curing the first sealing material;
forming an injection hole having an opening for injecting the electrolytic solution into the space;
after the pressure inside the space is reduced to a pressure range of from 200 Pa to 5,000 Pa inclusive within a vacuum chamber, injecting the electrolytic solution into the space by bringing the electrolytic solution into contact with the opening and then opening the vacuum chamber to atmosphere; and,
after injection of the electrolytic solution into the space, hermetically sealing the space by providing a second sealing material to the injection hole, leaving a pre-module to stand in a thermostatic chamber in a temperature range of from -40°C to 0°C inclusive for a prescribed time to thereby draw the second sealing material to an electrolytic solution side of the injection hole, and, after completion of drawing of the second sealing material, curing the second sealing material within the thermostatic chamber.

16. The method for manufacturing according to claim 15,
wherein, in the step of injecting the electrolytic solution, the pressure inside the vacuum chamber is 3,000 Pa.

17. The method for manufacturing according to claim 15 or 16,
wherein, in the step of hermetically sealing the space, the temperature of the thermostatic chamber is -20°C.

18. The method for manufacturing according to any of claims 15 to 17,
wherein, in the step of hermetically sealing the space, the prescribed time is from 1 minute to 10 minutes inclusive.

19. The method for manufacturing according to any of claims 15 to 18,
wherein, in the step of forming the space, the first sealing material is cured to form a first sealing member,
wherein, in the step of hermetically sealing the space, the second sealing material is cured to form a second sealing member, and
wherein the method of manufacturing further comprises, after the step of hermetically sealing the space, the step of obtaining the dye-sensitized solar cell in which, in a cross section parallel to a principal surface of the first substrate and including the injection hole, a distance H is larger than a width h of the opening of the injection hole, where the distance H is a distance between two contact points at which the first sealing member, the second sealing member, and the electrolytic solution are in contact with each other.
